Europäisches Patentamt

European Patent Office

Office européen des brevets

(11) Publication number: **0 247 158 B1**

(12) EUROPEAN PATENT SPECIFICATION

(45) Date of publication of patent specification: **18.03.92**

(51) Int. Cl.5: **C30B 1/02**, C30B 29/06, C30B 29/40

(21) Application number: **86907202.5**

(22) Date of filing: **19.11.86**

(86) International application number:
**PCT/US86/02490**

(87) International publication number:
**WO 87/03306 (04.06.87 87/12)**

(54) **METHOD FOR FABRICATING ARTICLES HAVING HETEROEPITAXIAL STRUCTURES.**

(30) Priority: **22.11.85 US 801063**
**29.09.86 US 912669**

(43) Date of publication of application:
**02.12.87 Bulletin 87/49**

(45) Publication of the grant of the patent:
**18.03.92 Bulletin 92/12**

(84) Designated Contracting States:
**DE FR GB IT NL**

(56) References cited:
**US-A- 4 046 618**

**Applied Physics Letters, vol. 42, no. 11, June 1983, K. Okamoto et al. : " Fabrication of GaAs-Mo-Si structures by metalorganic chemical vapor deposition and laser annealing ", see pages 972-974**

(73) Proprietor: **AMERICAN TELEPHONE AND TELEGRAPH COMPANY**
**550 Madison Avenue**
**New York, NY 10022(US)**

(72) Inventor: **CHAND, Naresh**
**461 Park Avenue**
**Berkeley Heights, NJ 07922(US)**
Inventor: **PFEIFFER, Loren, Neil**
**Red Gate Road**
**Morristown, NJ 07969(US)**
Inventor: **PHILLIPS, Julia, Mae**
**9 Crestwood Common 2219 North Avenue**
**Scotch Plains, NJ 07090(US)**

(74) Representative: **Watts, Christopher Malcolm Kelway et al**
**AT&T (UK) LTD. AT&T Intellectual Property Division 5 Mornington Road**
**Woodford Green Essex IG8 OTU(GB)**

## Description

### Field of the Invention

This invention pertains to formation or improvement of single crystal heteroepitaxial structures by a method comprising solid-state rapid thermal annealing, and to articles, e.g., semiconductor devices, produced thereby.

### Background of the Invention

From the beginning of semiconductor device technology, scientists have discussed a host of heteroepitaxial structures, i.e., combinations of layers of different materials in a single composite crystal. The fascination in this kind of structure is traceable to the wide selection of electrical properties thus potentially available to the device designers. The early visions of a wide variety of such structures have not yet been realized, however, and it is now recognized that heteroepitaxial structures with perfection suitable for state of the art devices are in general extremely difficult to produce.

Some types of heteroepitaxial semiconductor structures, e.g., combinations of III-V compound semiconductors of varying compositions, are well known to the art and are widely used in optical and electronic devices. Some heterostructures comprising a semiconductor substrate and a metal layer deposited thereon are also known to the art. For instance, U.S. Patent 4,492,971 discloses silicon/metal silicide heterostructures. The patent teaches that such structures can, for instance, be formed by co-deposition of metal and silicon onto the single crystal silicon substrate, with the substrate maintained at a temperature that favors formation of the stoichiometric metal silicide. U.S. Patent 4,477,308 discloses a method for forming an epitaxial layer of multiconstituent material on a substrate, the method comprising deposition of a very thin template layer onto the substrate material, followed by deposition of further material at a higher substrate temperature.

The above referred to references teach formation of heteroepitaxial structures by adjusting the conditions such that the deposition of overlayer material directly results in growth of the epitaxial and highly perfect overlayer. Although this approach is successful in a number of material combinations, e.g., silicon/metal silicide, there exist many material combinations for which this approach either does not work or is considered not likely to work.

The prior art also teaches that some heteroepitaxial structures can be formed by methods comprising transient melting of material. For instance, H. Ishiwara et al, Material Research Society Symposium, Proceedings, Volume 1, pp. 525-531 (1981), disclose that a heteroepitaxial Si/CoSi$_2$/Si structure can be formed by depositing a layer of Co onto a Si substrate, heating the substrate to form the cobalt silicide, depositing a layer of amorphous Si atop the silicide, and melting the amorphous Si by means of a high powered laser. Formation of a heteroepitaxial structure by means of transient melting of the top layer is also disclosed in co-assigned U.S. Patent 4,555,301 issued on November 26, 1985 to J. M. Gibson et al.

Various means for heating wafer-like samples during processing are known to the art. For instance, D. J. Lischner et al, Materials Research Society Symposium, Proceedings, Volume 4, pp. 759-764 (1982), disclose annealing of ion-implanted Si by means of a battery of tungsten halogen lamps, J. C. C. Fan et al, (ibid, pp. 751-758), disclose transient heating of wafer-shaped materials (e.g., Si) by means of a graphite strip heater, and C. Hill, Materials Research Society Symposium, Proceedings, Volume 13 (1983), pp. 381-392, discusses beam processing in semiconductor technology.

As demonstrated by the above discussed references, the prior art knows techniques that can be used to produce some heteroepitaxial structures. However, frequently the crystalline quality of the epitaxial overlayer (or other relevant material parameter of the heterostructure is relatively low, making the material unsuitable, or of marginal utility, for device applications. Examples of heterostructures of technological promise that suffer from low crystalline quality of the epitaxial overlayer are Si/Al$_2$O$_3$ (Si-on-sapphire) and GaAs/Si. An example of a heterostructure in which another material parameter is frequently of a relatively low value is Si$_x$Ge$_{1-x}$/Si ($0 \leq x > 1$), with the parameter being the room temperature carrier mobility.

It has recently been discovered that the crystalline quality of the overlayer of a particular heterostructure (CaF$_2$/Si) can be substantially improved by a rapid thermal anneal (RTA). See, for instance, Pfeiffer et al., Applied Physics Letters, Volume 46, No. 10, pages 947-949, 15 May 1985.

In view of the fact that many material combinations, such as Si-on-sapphire, GaAs/Si, and Si$_x$Ge$_{1-x}$/Si, are of potential interest in technology, especially in semiconductor device technology, a broadly applicable processing technique that can result in the transformation of lower quality overlayer material into higher quality material that is epitaxial with its substrate would be of much interest. This application discloses such a technique.

### Summary of the Invention

According to the invention there is provided a method as set out in claim 1. Particular forms of the method are set out in the dependent claims.

Glossary

A crystalline layer atop a single crystal substrate herein is considered to be "epitaxial" with the substrate if the overlayer is a single crystal and the crystalline orientation of the overlayer is determined by the crystalline orientation of the substrate.

A layer of crystalline material herein is considered to be "polycrystalline" if $\chi_{min}$ (i.e., the room temperature ratio of RBS is an appropriate low-index lattice direction (typically chosen normal to the layer) to that in a random lattice direction) is greater than at least about 20%, for a 1-2 MeV He probe beam of about 1 mm$^2$ cross section. In amorphous material $\chi_{min}$ is of course 100%.

A crystalline layer is considered herein to be "single crystalline" if its $\chi_{min}$, determined with a similar probe beam, is less than about 20%, preferably less than 10 or even 5%, along two crystalline directions.

The $\chi_{min}$ of crystals known to be essentially perfect is found to be about 3%, the exact value depending on the material. For $\chi_{min}$ between about 3 and about 20%, $\chi_{min}$ is a generally accepted measure of crystal perfection. However, in epitaxial films that are found to have $\chi_{min} \sim 3\%$ and that are thus considered to be essentially perfect according to the $\chi_{min}$ criterion, possible differences of crystalline perfection may be established by other means. One such other measure of crystalline perfection is the observed room temperature carrier mobility ($\mu$) in the material. This measure can be used, for instance, for heteroepitaxial semiconductors, e.g. $Si_xGe_{1-x}/Si$.

Herein the relevant pre-RTA (Rapid Thermal Anneal) measure of second material crystal perfection is identified by the subscript i (e.g., $\chi_{min,i}$, $\mu_i$), and the post-RTA measure by the subscript f (e.g., $\chi_{min,f}$, $\mu_f$). The "normalized change" in the appropriate measure of second material crystal perfection herein is designated $\Delta \chi_{min}$, $\Delta \mu$, etc., where $\Delta \chi_{min} = (\chi_{min,i} - \chi_{min,f})/\chi_{min,i}$, and $\Delta \mu = (\mu_f - \mu_i)/\mu_f$.

An epitaxial layer of material atop a single crystal substrate is herein considered to form a "heteroepitaxial" structure if the substrate (the "first material") substantially differs from the overlayer (the "second material") in chemical composition. In particular, at least one chemical element that is a major constituent of the first (second) material is not a major constituent of the second (first) material. For purposes of this definition a constituent is a "major" constituent if it makes up at least 5% by weight of the material.

Brief Description of the Drawings

FIGS. 1 and 2 schematically depict exemplary heterostructures;
FIG. 3 schematically depicts apparatus for rapid thermal annealing;

The Invention

We have discovered that the crystalline perfection (as expressed by $\chi_{min}$, $\mu$, or in other appropriate ways) of a layer of material (the "second" material) deposited onto an appropriate single crystal substrate (the "first" material) can, under appropriate conditions, be substantially improved by means of a rapid thermal anneal (RTA). Typically, the inventive method produces a normalized change in the appropriate measure of crystal quality of at least about 0.1. Thus, $\Delta \chi_{min} \geq 0.1$, or $\Delta \mu \geq 0.1$. For instance, the $\chi_{min,i}$ of as deposited second material frequently is greater than 10%, even 20 or 50%, and the inventive method can produce therefrom high quality epitaxial material having $\chi_{min,f}$ of less than 10%, even 5%.

The method is currently believed to have wide applicability and may, for instance, permit (when applied sequentially) the fabrication of heteroepitaxial structures comprising any desired number of layers of appropriately chosen single crystal material. In such a case, the last layer to be transformed into single crystal material forms the substrate for the next layer to be formed, and the term "substrate" herein is to be understood in this broader sense. Exemplary material combinations to which the invention method can advantageously be applied are silicide/Si, $Si_xGe_{(1-x)}/Si$, with $0 < x \leq 1$, GaAs/Si, and $Si/Al_2O_3$. Typically, the first and second material lattice constants must differ by less than 10% for epitaxy to be possible.

The inventive method typically comprises preparation of a major surface of a single crystal substrate, typically a semiconductor wafer that is cut substantially parallel to a low-index (e.g., within about ± 5° of a (100), (111), or (1l02)) lattice plane, by known methods, such as to provide a substantially atomically clean and undamaged substrate surface. See, for instance, A. Ishizaka et al, Proceedings, Second International Symposium on Molecular Beam Epitaxy, Tokyo, 1982, pp. 183-186. Onto the thus prepared first material surface all the material needed to yield the desired layer thickness of second material is deposited. In case the second material is a multiconstituent material, deposition is often advantageously codeposition. During deposition the substrate temperature can be raised to any desired level, so long as the materials neither melt nor chemically-react. However, it is currently considered to be a significant feature of the instant invention that the substrate can be maintained at a relatively low temperature during deposition, typically below 0.5 $T_{m2}$, where $T_{m2}$ is the absolute melting temperature of the second material, and even below 300 or 200°C.

The thus deposited second material, which has the same overall chemical composition as the desired single crystal epitaxial second material but which is typically polycrystalline, is then subjected to a RTA by any appropriate means. The RTA involves heating at least the deposited second material to an annealing temperature $T_{a2}$, and maintaining the deposited second material at the annealing temperature for an annealing time $t_{a2}$.

By the "annealing temperature" we mean herein a temperature that permits atomic rearrangement of the deposited second material, typically a temperature greater than 0.75 $T_{m2}$ but less than $T_{m2}$, preferably between 0.8 and 0.95 $T_{m2}$. By an "annealing time" we mean herein a time sufficient to result in transformation of the deposited second material into single crystal second material at the annealing temperature. For instance, for Si-on-sapphire ($Al_2O_3$),$t_{a2}$ typically is in the range 1-60, or frequently 5-40 seconds, and these ranges we consider to be broadly applicable.

A further condition on $T_{a2}$ and $t_{a2}$ is the requirement that the chemical composition of the resulting second material layer be substantially identical to that of the as deposited second material. This obviously requires that substantially no mass transfer across, or chemical reaction at, substrate/deposit interface occurs, and sets upper limits on the allowable combinations of $T_{a2}$ and $t_{a2}$. A further requirement is that $T_{a2}$ be less than the melting temperature of the first material, as well as of any other material in a multi-material heterostructure.

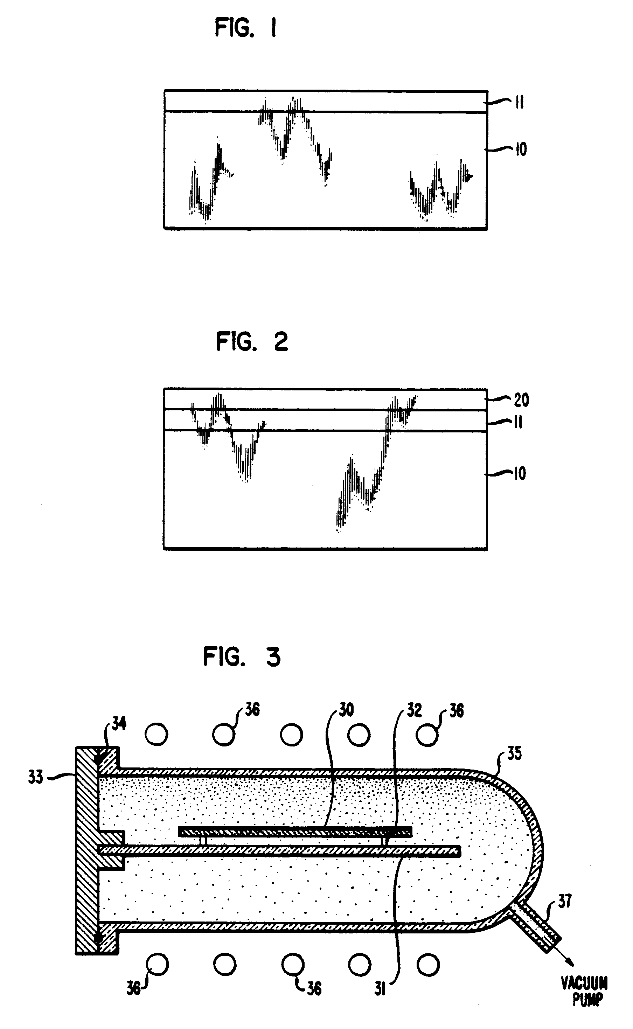

FIG. 1 schematically depicts the simplest possible epitaxial heterostructure, namely, a first material single crystal substrate 10 and a second material single crystal overlayer 11 that is epitaxial with 10. For instance, 10 could be a Si wafer, and 11 a semiconductor such as Ge or GaAs or a metal silicide such as $CoSi_2$. FIG. 2 schematically shows a slightly more complicated epitaxial heterostructure comprising single crystal material 10 (e.g., Si), epitaxial single crystal material 11 (e.g., $CoSi_2$) thereon, and epitaxial single crystal material 20 (e.g., Si) atop 11. It will be recalled that herein 10 is considered to be the substrate for purposes of formation of 11, whereas 11 is considered to be the substrate for purposes of formation of 20. The scheme is to be extended in the case of more complicated epitaxial heterostructures. In electronic devices according to the invention means for making electrical contact to appropriate layers of the heterostructure would of course be provided. Such means are well known and are not shown.

The inventive method comprises a RTA, carried out by any appropriate means. Such means are well known in the art. See, for instance, D. J. Lischner et al (op. cit.), and J. C. C. Fan et al (op. cit.). Exemplary apparatus for carrying out a RTA according to the invention is schematically shown in FIG. 3, wherein sample 30 (e.g., a Si wafer with a layer of composition $Si_{.8}Ge_{.2}$ thereon) is supported by transparent (e.g., fused silica) sample holder 31 having sample supporting posts 32. The sample holder is attached to cover plate 33 which can form an airtight seal with transparent chamber 35 by means of O-ring 34. Means 37 are provided for attaching the apparatus to a vacuum system. Not shown are other well known means that may advantageously be present in a RTA apparatus, e.g., resistive heater means, temperature measuring means (e.g., thermocouples), means for admitting inert gas to the chamber, and means for depositing second material onto the substrate (e.g., e-beam, Knudsen, or other evaporators, or sputtering means). Radiant energy sources 36 are shown placed outside of 35, and such placement is currently preferred for high intensity lamps, e.g., tungsten halogen lamps. However, other heat sources (e.g., a graphite wire heater) could be advantageously placed inside the chamber. In order to achieve substantially uniform heating of 30 during RTA it is desirable that the radiant flux from the sources 36 be substantially homogeneous. This can be achieved, for instance, by interposing a diffusing surface between the lamps and the sample, e.g., by sandblasting or otherwise roughening the outside of 35, or by providing a large area heat source.

Particularly advantageous apparatus for practicing the invention comprises means for final in situ preparation of the initial substrate (e.g., by means of oxidation, followed by heating in UHV to remove the oxide, or by sputtering), means for in situ forming the second material layer atop the initial substrate, and, if desired, means for forming in situ one or more further layers of material. With such apparatus it is in principle possible to form heterostructures comprising any desired number of layers without exposing the incomplete heterostructure to a contaminating atmosphere, and this is currently considered by us to be a preferred approach. In particular, we believe that it is frequently advantageous to carry out the deposition(s) and the RTA(s) under conditions such that the $O_2$ partial pressure is at most about $10^{-2}$ Pa, preferably less than $10^{-3}$ Pa.

As will be appreciated, by those skilled in the art, the appropriate annealing time depends not only on the second material and possibly also on the first material, but is also a strong function of the annealing temperature. No universally valid limits can thus be determined, but we believe that typically $t_{a2}$ will be in the range 1-60 seconds, with $t_{a2}$ decreasing as $T_{a2}$ increases.

Typically, there exists an upper limit in $T_{a2}$ above which the crystalline quality of the annealed material decreases. It will undoubtedly be appreciated by those skilled in the art that the exact value of the upper limit depends on the second material, $t_{a2}$, and possibly also on the first material. Typically, however, $T_{a2} < 0.95\ T_{m2}$, and frequently $T_{a2} < 0.9\ T_{m2}$. In the case of silicon-on-sapphire, we have found that $T_{a2}$ is advantageously chosen in the range 1250°C to about 1410°C, and for GaAs/Si in the range 750 to about 900°C.

For some material combinations, typically when the differential thermal expansion of substrate and overlayer exceeds about 1% between room temperature and $T_{a2}$, cracking or buckling of the overlayer may occur during cool-down after the RTA. This can often be prevented by a thermal soak after RTA, i.e., by maintaining the sample at a soak temperature $T_{s2}$ ($0.5\ T_{m2} < T_{s2} < 0.75\ T_{m2}$) for a time $t_{s2}$ ($1 < t_{s2} < 60$ seconds).

## Example I

The Si layer of a commercially available (Union Carbide, San Diego, California) $Si/Al_2O_3$ heterostructure has a $\chi_{min}$ of about 20%. The sample is placed into a furnace, the furnace is sealed, flushed with Ar for about 10 minutes, and thereafter the furnace power is ramped up at about 15% per second until the annealing temperature of about 1200°C is reached. This temperature is held for about 20 seconds, and then the furnace power is decreased at 15% per second. The sample is maintained in the furnace until the sample temperature has dropped to about 100°C. This procedure results in a heteroepitaxial structure, with the Si having a $\chi_{min}$ of about 5%.

## Example II

On a $n^+$ Si(100) substrate were sequentially deposited by MBE (using multiple guns)
 a) 470 nm Si ($p^+$, $1 \cdot 10^{18}$ cm$^{-3}$);
 b) 25 nm of undoped Si;
 c) 50 nm of undoped $Ge_{.2}Si_{.8}$ alloy;
 d) 25 nm of undoped Si; and
 e) 75 nm of Si($p^+$, $1\ 10^{18}$ cm$^{-3}$).
All layers were deposited at a substrate temperature of 500°C, in a vacuum of at least about $10^{-7}$ Pa. Further details of the procedure can be found in U.S. Patent No. 4,529,455.

The thus produced heterostructure had essentially ideal $\chi_{min}$ ( 3%) throughout, the hole mobility in the alloy at 60°K was about 140 cm$^2$/volt sec.

After a RTA ($T_{a2}$ = 1080°C, $t_{a2}$ = 11 seconds) substantially as described in Example 1, the hole mobility was 210 cm$^2$/volt sec, with $\chi_{min}$ remaining about 3%.

## Example III

A $Si/Al_2O_3$ heterostructure (orientation (100) and (1I02), respectively), is subjected to a RTA($T_{a2}$ = 1410°C, $t_{a2}$ = 15 seconds). The resulting combination is heteroepitaxial, with the Si having a $\chi_{min}$ of less than 5%.

## Example VI

A single crystal Si substrate (oriented about 3° off (100) towards < 011 >) was prepared by a known method, and a $2\mu m$ GaAs layer grown thereon by MBE, substantially as described by R. Fischer et al, Journal of Applied Physics, Vol. 58, p. 374 (1985). In particular, the final step in the substrate preparation was formation of a thin oxide layer by maintaining the substrate for 5 minutes in a 80°C solution of composition $3HCl \cdot 3H_2O_2 \cdot 5H_2O$. Before starting the MBE growth, the substrate was heated to about 900°C to thermally desorb the oxide layer, and 10 minutes after oxide removal was complete the arsenic cell shutter was opened and the substrate cooled to about 425°C. A thin GaAs layer (about 25nm) was then deposited at a growth rate of about .2 $\mu m$/hour. The substrate temperature and deposition rate were then slowly increased to about 595°C and 1 $\mu m$/hour, respectively, to start the normal growth of the GaAs.

RTA was performed in a commercially available heat pulse system in a forming gas atmosphere (the GaAs/Si sample placed upside down onto a GaAs substrate, ($T_{a2}$ about 900°C, $t_{a2}$ about 10 seconds) the rise and cooling times of the annealer were about 10 and 6 seconds, respectively.

The annealed combination had a substantially lower percentage of displaced atoms near the GaAs/Si interface (decreased to 7% from 20%, as estimated by RBS), decreased width of the (400) peak in the rocking curve (from 400 to 185 arc seconds), greatly increased photoluminescent intensity, and greatly decreased etch pit density, as compared to a similarly grown GaAs/Si combination that was not subjected to RTA. In the annealed GaAs, avalanche photodiodes were made, and RTA was found to improve the yield significantly.

It will be appreciated by those skilled in the art that the above cited conditions are exemplary only. For instance, the substrate can be oriented differently, including exact (100) orientation, the template layer deposition temperature can be different (e.g., about 150°C), the GaAs growth temperature is advantageously chosen in the approximate range 580-610ºC, and $T_{a2}$ is advantageously in the approximate range 750-900ºC. The improvement in the crystalline quality of the GaAs that is attained by RTA according to the invention typically depends on the quality of the starting material.

## Claims

1. Method for fabricating an article comprising a composite structure of a single crystal first material substrate and a layer of a crystalline second material overlying the substrate, the lattice constants of the first and second materials differing by less than ten per cent, the second material layer being epitaxial with the substrate
   CHARACTERIZED BY
   a) providing a composite structure of a first material single crystal substrate and a crystalline layer of second material on the substrate, the second material having a RBS ratio $\chi_{min,i}$ and a predetermined chemical composition, the chemical composition of the second material differing from that of the first material, the first material chosen from the group consisting of the semiconductors, metal silicides and $Al_2O_3$, and the second material chosen from the group consisting of the semiconductors and the metal silicides; and
   b) heating at least the second material to an annealing temperature $T_{a2}$ for a time $t_{a2}$, with $0.75\ T_{m2} < T_{a2} < T_{m2}$, and $1 \leq t_{a2} \leq 60$ seconds, where $T_{m2}$ is the second material absolute melting temperature, and with $T_{a2}$ and $t_{a2}$ chosen such that, after completion of the heating, the second material still has essentially the predetermined chemical composition and
   (i) the second material has $\chi_{min,f}$ such that $\Delta\chi_{min} \geq 0.1$, where $\Delta\chi_{min} = \chi_{min,i}-\chi_{min,f})/\chi_{min,i}$ or
   (ii) if prior to the heating step a room temperature carrier mobility $\mu_i$ is associated with the composite structure, then the heating is conducted such that a room temperature carrier mobility $\mu_f$ is associated with the composite structure, such that $\Delta\mu > 0.1$, where $\Delta\mu = (\mu_f-\mu_i)/\mu_f$, or
   (iii) both.

2. Method according to claim 1,
   CHARACTERIZED IN THAT
   at least step b) is carried out in an atmosphere having an $O_2$ partial pressure less than about $1 \times 10^{-2}$ Pa.

3. Method according to claim 1,

4. Method according to claim 1,
   CHARACTERIZED IN THAT
   the single crystal first material substrate consists of a layer (11) of said first material formed on a single crystal substrate (10) of a third material, the third material composition differing from at least the first material composition, said first material having $\chi_{min} < 10\%$, the crystalline layer (20) of second material being formed on said layer of first material.

5. Method according to claim 4,
   CHARACTERIZED IN THAT
   the formation of the layer of first material comprises depositing first material on the third material substrate and heating the deposited first material to an annealing temperature $T_{a1}$ for a time $t_{a1}$, with $T_{a1}$ and $t_{a1}$ chosen such that the first material with $\chi_{min} < 10\%$ is produced.
   CHARACTERIZED IN THAT
   $\chi_{min,i} > 10\%$ and $\chi_{min,f} \leq 5\%$.

6. Method according to claim 1,
   CHARACTERIZED IN THAT
   the first material is $Al_2O_3$ and the second material is Si.

7. Method according to claim 6,
   CHARACTERIZED IN THAT
   $T_{a2}$ is in the range from about 1250°C to about 1410°C.

8. Method according to claim 1,
   CHARACTERIZED IN THAT
   the first material is Si, and the second material is GaAs.

9. Method according to claim 8,
   CHARACTERIZED IN THAT
   $T_{a2}$ is in the range from about 750°C to about 900°C.

10. Method according to claim 1,
    CHARACTERIZED IN THAT
    the first material consists substantially of Si, and the second material consists substantially of material of composition $Si_xGe_{1-x}$, $0 < x \leq 1$.

11. Method according to claim 1,
    CHARACTERIZED IN THAT
    after completion of step b), the temperature of the composite structure is reduced to a soak temperature $T_{s2}$, where $0.5\ T_{m2} < T_{s2} < 0.75\ T_{m2}$, and the composite structure maintained at the soak temperature for a time $t_{s2}$,

where $1 < t_{s2} < 60$ seconds.

**Revendications**

1. Procédé de fabrication d'un article comprenant une structure composite formée par un substrat en un premier matériau monocristallin, et par une couche d'un second matériau cristallin recouvrant le substrat, les constantes de réseau des premier et second matériaux différant de moins de 10 %, et la couche du second matériau étant épitaxiale, vis-à-vis du substrat
CARACTERISE EN CE QUE
a) on forme une structure composite comprenant un substrat monocristallin en un premier matériau et une couche cristalline d'un second matériau sur le substrat, le second matériau ayant un rapport de RBS $\chi_{min,i}$, et une composition chimique prédéterminée, la composition chimique du second matériau étant différente de celle du premier matériau, le premier matériau étant choisi dans le groupe qui comprend les semiconducteurs, les silciures de métal et $Al_2O_3$, et le second matériau étant choisi dans le groupe qui comprend les semiconducteurs et les siliciures de métal ; et
b) on chauffe au moins le second matériau jusqu'à une température de recuit $T_{a2}$ pendant une durée $t_{a2}$, avec $0,75\ T_{m2} < T_{a2} < T_{m2}$, et $1 \leq t_{a2} \leq 60$ secondes en désignant par $T_{m2}$ la température absolue de fusion du second matèriau, et avec $T_{a2}$ et $t_{a2}$ choisies de façon qu'après l'achèvement du chauffage, le second matériau ait toujours pratiquement la composition chimique prédéterminée, et
(i) le second matériau a un paramètre $\chi_{min,f}$ tel que $\Delta\chi_{min} \geq 0,1$ avec $\Delta\chi_{min} = (\chi_{min,i}-\chi_{min,f})/\chi_{min,i}$, ou
(ii) si avant l'étape de chauffage, une mobilité des porteurs à la température ambiante $\mu_i$ est associée à la structure composite, le chauffage est alors effectué de façon qu'une mobilité des porteurs à la température ambiante $\mu_f$ soit assosiée à la structure composite, pour avoir $\Delta\mu > 0,1$, avec $\Delta\mu = (\mu_f-\mu_i)/\mu_f$, ou
(iii) les deux.

2. Procédé selon la revendication 1,
CARACTERISE EN CE QUE
L'étape b), au moins, est accomplie dans une atmosphère ayant une pression partielle de $O_2$ inférieure à environ $1 \times 10^{-2}$ Pa.

3. Procédé selon la revendication 1,
CARACTERISE EN CE QUE

$\chi_{min,i} > 10\ \%\ \chi_{min,f} \leq 5\ \%$.

4. Procédé selon la revendication 1,
CARACTERISE EN CE QUE
le substrat formé par le premier matériau monocristallin consiste en une couche (11) du premier matériau qui est formée sur un substrat monocristallin (10) d'un troisième matériau, la composition du troisième matériau étant différente au moins de la composition du premier matériau, le premier matériau ayant un paramètre $\chi_{min} < 10\ \%$, et la couche cristalline (20) du second matériau étant formée sur la couche précitée du premier matériau.

5. Procédé selon la revendication 4,
CARACTERISE EN CE QUE
la formation de la couche du premier matériau comprend :
le dépôt du premier matériau sur le substrat formé par le troisième matériau, et
le chauffage du premier matériau déposé, jusqu'à une température de recuit $T_{a1}$, pendant une durée $t_{a1}$, avec $T_{a1}$ et $t_{a1}$ choisies de façon à produire le premier matériau avec $\chi_{min} < 10\ \%$.

6. Procédé selon la revendication 1,
CARACTERISE EN CE QUE
le premier matériau consiste en $Al_2O_3$ et le second matériau consiste en Si.

7. Procédé selon la revendication 6,
CARACTERISE EN CE QUE
$T_{a2}$ est dans la plage d'environ 1250° C à environ 1410° C.

8. Procédé selon la revendication 1,
CARACTERISE EN CE QUE
le premier matériau consiste en Si, et le second matériau consiste en GaAs.

9. Procédé selon la revendication 8,
CARACTERISE EN CE QUE
$T_{a2}$ est dans la plage comprise entre environ 750° C et environ 900° C.

10. Procédé selon la revendication 1,
CARACTERISE EN CE QUE
le premier matériau consiste pratiquement en Si, et le second matériau consiste pratiquement en un matériau ayant la composition $Si_xGe_{1-x}$ , $0 < x \leq 1$.

11. Procédé selon la revendication 1,
CARACTERISE EN CE QUE
après l'achèvement de l'étape b), on réduit la température de la structure composite jusqu'à une température de stabilisation $T_{s2}$, avec $0,5\ T_{m2} < T_{s2} < 0,75\ T_{m2}$, et on maintient la structure composite à la température de stabilisation pendant une durée $t_{s2}$, avec $1 < t_{x2} < 60$ secondes.

**Patentansprüche**

1. Verfahren zur Herstellung eines Bauteils mit einem zusammengesetzten Aufbau aus einem ersten einkristallinen Substratmaterial und einer Schicht aus einem kristallinen zweiten Material auf dem Substrat, wobei die Gitterkonstanten des ersten und des zweiten Materials sich um weniger als 10 % unterscheiden und die Schicht aus dem zweiten Material epitaxial mit dem Substrat ist, gekennzeichnet durch die Schritte:

   a) Bereitstellen eines zusammengesetzten Aufbaus eines ersten einkristallinen Substratmaterials und einer kristallinen Schicht eines zweiten Materials auf dem Substrat, wobei das zweite Material ein RBS-Verhältnis $\chi_{min,i}$ und eine vorbestimmte chemische Zusammensetzung hat, die verschieden von der des ersten Materials ist, das erste Material aus der aus den Halbleitern bestehenden Gruppe Metallsiliciden und $Al_2O_3$ ausgewählt und das zweite Material aus der aus den Halbleitern bestehenden Gruppe und den Metallsiliciden ausgewählt ist, und
   b) Erhitzen wenigstens des zweiten Materials auf eine Anlaßtemperatur $T_{a2}$ für eine Zeit $t_{a2}$ mit
   $0,75\ T_{m2} < T_{a2} < T_{m2}$ und $1 \leq t_{a2} \leq 60$ Sekunden, wobei $T_{m2}$ die absolute Schmelztemperatur des zweiten Materials ist und $T_{a2}$ und $t_{a2}$ so gewählt sind, daß nach Beendigung des Erhitzens das zweite Material im wesentlichen weiter die vorbestimmte chemische Zusammensetzung hat, und
   (i) das zweite Material einen Wert $\chi_{min,f}$ hat, derart, daß $\Delta\chi_{min} \leq 0,1$, wobei $\Delta\chi_{min} = (\chi_{min,i} - \chi_{min,f})/\chi_{min,i}$ ist, oder
   (ii) wenn vor dem Erhitzungsschritt dem zusammengesetzten Aufbau eine Raumtemperatur-Trägerbeweglichkeit $\mu_i$ zugeordnet ist, dann wird die Erhitzung so ausgeführt, daß dem zusammengesetzten Aufbau eine Raumtemperatur-Trägerbeweglichkeit $\mu_f$ zugeordnet ist, derart, daß $\Delta\mu > 0,1$ ist, wobei $\Delta\mu = (\mu f - ui)/\mu f$ ist, oder
   (iii) beides.

2. Verfahren nach Anspruch 1, dadurch gekennzeichnet, daß wenigstens der Schritt b) in einer Atmosphäre mit einem $O_2$-Partialdruck kleiner als etwa $1 \times 10^{-2}$ Pa ist.

3. Verfahren nach Anspruch 1, dadurch gekennzeichnet, daß $\chi_{min,i} > 10\%$ und $\chi_{min,f} \leq 5\%$ .

4. Verfahren nach Anspruch 1, dadurch gekennzeichnet, daß das einkristalline erste Substratmaterial aus einer Schicht (11) des ersten Materials besteht, die auf einem einkristallinen Substrat (10) eines dritten Materials gebildet ist, wobei die Zusammensetzung des dritten Materials sich von wenigstens der des ersten Materials unterscheidet, das erste Material einen Wert $\chi_{min} < 10\%$ hat und die kristalline Schicht (20) des zweiten Materials auf der Schicht des ersten Materials gebildet ist.

5. Verfahren nach Anspruch 4, dadurch gekennzeichnet, daß die Bildung der Schicht aus dem ersten Material das Abscheiden des ersten Materials auf das dritte Substratmaterial und das Erhitzen des abgeschiedenen ersten Materials auf eine Anlaßtemperatur $T_{a1}$ für eine Zeit $t_{a1}$ umfaßt, wobei $T_{a1}$ und $t_{a1}$ so gewählt sind, daß das erste Material mit einem Wert $\chi_{min} < 10\%$ erzeugt wird.

6. Verfahren nach Anspruch 1, dadurch gekennzeichnet, daß das erste Material $Al_2O_3$ und das zweite Material Si sind.

7. Verfahren nach Anspruch 6, dadurch gekennzeichnet, daß $T_{a2}$ im Bereich von etwa $1250\degree C$ bis etwa $1410\degree C$ liegt.

8. Verfahren nach Anspruch 1, dadurch gekennzeichnet, daß das erste Material Si und das zweite Material GaAs sind.

9. Verfahren nach Anspruch 8, dadurch gekennzeichnet, daß $T_{a2}$ im Bereich von etwa $750\degree C$ bis etwa $900\degree C$ liegt.

10. Verfahren nach Anspruch 1, dadurch gekennzeichnet, daß das erste Material im wesentlichen aus Si und das zweite Material im wesentlichen aus einem Material der Zusammensetzung $Si_xGe_{1-x}$, $0 < x \leq 1$ ist.

11. Verfahren nach Anspruch 1, dadurch gekennzeichnet, daß nach Beendigung des Schritts b) die Temperatur des zusammengesetzten Aufbaus auf eine Kühltemperatur $T_{s2}$ verringert wird, wobei $0,5\ T_{m2} < T_{s2} < 0,75\ T_{m2}$ ist und der zusammengesetzte Aufbau auf der Abkühltemperatur für eine Zeit $t_{s2}$ gehalten wird, wobei $1 < t_{s2} < 60$ Sekunden ist.

FIG. 1

FIG. 2

FIG. 3

VACUUM
PUMP